# EUROPEAN PATENT APPLICATION

(11) **EP 1 646 270 A1**
(43) Date of publication of application: **12.04.2006**
(21) Application number: 04747136.2
(22) Date of filing: 30.06.2004
(51) Int. Cl.: H05K 3/28, H05K 3/46, H05K 3/26

(54) **CIRCUIT BOARD AND PROCESS FOR PRODUCING THE SAME**

(30) Priority: 10.07.2003 JP 2003195114
(71) Applicant: Nippon Mektron, Ltd., Minato-ku, Tokyo 105-0012 (JP)
(72) Inventor: TANAKA, Hideaki, Ushiku-shi, Ibaraki 300-1221 (JP); Sensui, Nobuyuki, Ushiku-shi, Ibaraki 300-1236 (JP)
(74) Representative: W.P. Thompson & Co.
(86) International application number: PCT/JP2004/009667
(87) International publication number: WO 2005/006825

(57) **Abstract**

In the case of using a photosensitive insulating resin for a surface protective layer of a circuit wiring pattern, or for an insulating layer between circuit wiring conductor layers in a circuit board, Na ions adsorbed on the photosensitive insulating resin are replaced with a polyvalent metal through a treatment step containing Na ions which is executed after a heat curing step of the photosensitive insulating resin. For the polyvalent metal, a II group including Mg or Ca can be selected.

## Description

### Technical Field

The present invention relates to a circuit board and its manufacturing method, and more particularly to a circuit board which has characteristics in formation of a surface protective layer of a circuit wiring pattern and formation of an interlayer insulating layer in the case of a multilayer circuit board, and its manufacturing method.

### Background Art

Promotion has recently been made of great miniaturization of a mounted pad portion of a circuit board such as a flexible circuit board by miniaturizing mounted components and achieving a high mounting density. This has brought about a difficulty of dealing with such miniaturization by a method of punching and sticking a cover film which has conventionally been used as a surface protective layer formed on a surface of a wiring pattern.

Recently, therefore, a photosensitive insulating resin has been employed in place of the cover film. This photosensitive insulating resin is subjected to exposure, development, water-washing, and curing to enable formation of a surface protective layer having a fine opening shape and a complex opening shape which has been difficult to be achieved by punching and sticking of the cover film.

In a method of forming a circuit board, a built-up type circuit board has come into frequent use, and a photosensitive insulating resin has been employed for an interlayer insulating layer.

Meanwhile, a reduction in weight and thickness of the circuit board has been accompanied by problems of bending of the substrate due to mismatching of material characteristics in a mainly epoxy or acrylic photosolder resist which conventionally becomes a hard film, and cracking in handling of a substrate manufacturing process. To avoid these problems, a photosolder resin which has a bulky molecular structure and in which a polymer such as urethane to become a flexible film is blended has been developed.

In the manufacturing process of the circuit board which has a surface protective layer or an interlayer insulating layer made of such a photosensitive insulating resin, an insulating film is formed through a step of coating or laminating a photosensitive insulating resin film on an insulating material base material on which a required wiring pattern is formed, an exposing step, a developing step, a UV curing and heat curing step. Subsequently, surface treatment such as plating is executed on a mounted pad portion of the circuit board on which the insulating film has been formed to complete a product.

In many cases, the photosensitive insulating resin is subjected to development by using an alkali developing solution, and then to water-washing. For the developing solution used in the developing step, an aqueous solution mainly containing sodium carbonate is used. The water-washing step during the development has conventionally been executed by properly combining city water-washing with pure water-washing.

In the conventional water-washing step, however, Na ions of the sodium carbonate are combined with a carboxyl group present in the insulating resin film in the developing step. The Na accelerates water absorption to the insulating film in an electric conduction test under a high temperature and high humidity, and works as an electrolyte, consequently reducing insulation performance of the insulating film.

Thus, short-circuiting occurs because of a dendrite formed by migration and precipitation of ionized copper from an anode side to a cathode side. Additionally, electric characteristics and mechanical physical properties may be reduced because the Na hydrolyzes a molecular chain of the resin which forms the film under the high temperature and the high humidity, and deteriorates a film quality.

As a conventional technology for removing the Na ions from the insulating film, there is a method of washing a circuit board by water containing Ca ions or Mg ions after alkali development, which is disclosed in, e.g., Japanese Patent Application Laid-Open No. 2000-208904, 2002-162739, or 2002-305368.

However, in the manufacturing of the circuit board, surface treatment such as plating is carried out after the formation of the insulating resin film. Such a step may include alkali treatment, and the Ca ions or the MG ions added in a developing solution or in a water-washing step after development may be partially replaced again with sodium. In the case of the method alone disclosed in Japanese Patent Application Laid-Open No. 2000-208904, 2002-162739, or 2002-305368, the aforementioned problems caused by the Na ions occur for such reasons.

### Disclosure of the Invention

Thus, the present invention provides a flexible circuit board wherein environmental resistance of a surface protective layer or an interlayer insulating layer is improved by subjecting an insulating resin film passed through heat curing treatment to ion replacement in polyvalent metal containing water in the case of manufacturing a circuit board which uses a surface protective layer of a circuit wiring pattern, and a photosensitive insulating resin as an interlayer insulating layer for a multilayer circuit board, and its manufacturing method.

To manufacture a circuit board, the present invention employs a method characterized by containing 0.1 wt% to 10 wt%, more preferably 0.5 wt% to 5 wt% of at least one of Mg ions and Ca ions in replacement water which is executed after curing treatment of the insulating resin film or surface treatment of the circuit board.

By this method, Na ions that enter the photosensitive insulating resin and are combined with a carboxyl group in the circuit board manufacturing process are replaced with Mg ions or Ca ions. Accordingly, by suppressing water absorption of the photosensitive resin film and hydrolysis of the resin, it is possible to provide a flexible circuit board inexpensively and stably while maintaining environmental resistance.

### Best Mode for Carrying out the Invention

Next, to explain an embodiment of the present invention, description will be made of a case of manufacturing a circuit board. According to the embodiment, as a photosensitive insulating resin, a negative type ultraviolet cured resin which is a film-like photosensitive insulating resin similar in shape to a dry film type resist is used.

To begin with, after a required wiring pattern is formed on a proper insulating base material surface in the usual manner, the process moves to a step of forming a surface protective layer on a surface of the wiring pattern. This surface protective layer is formed through a laminating step, an exposing step, a developing step, a UV curing step, and a heat curing step of the photosensitive insulating resin. After formation of an insulating film, the circuit board is subjected to surface treatment such as plating as occasion demands to become a product.

According to the invention, the circuit board is treated by using replacement water which contains Mg ions or Ca ions after the heat curing or the surface treatment step to remove Na ions combined with a carboxyl group, and to make replacement with Mg ions or Ca ions.

Additionally, the replacement with the Mg ions or the Ca ions executed after the heat curing or the surface treatment step of the invention may be used independently, or used together with the method disclosed in Japanese Patent Application Laid-Open No. 2000-208904, 2002-162739, or 2002-305368 to wash the circuit board by water containing Ca ions or Mg ions after alkali development.

Various studies have been made on a concentration of Mg ions or Ca ions in the replacement water. A result confirms that regarding a range of obtaining effects of the invention under device conditions for providing insulating performance, flexibility to the insulating resin film under a high temperature and high humidity, and an inexpensive circuit board, an operation is effective when a concentration of Mg ions or Ca ions in the replacement water is in a range of 0.1 wt% to 10 wt%, especially 0.5 wt% to 5 wt%.

The circuit board after electrolytic gold plating has been treated in replacement water which contains 1 wt% of Mg ions, and environmental resistance performance under a high temperature and high humidity has been investigated. A result shows that no reduction occurs in an insulating resistance value of an insulating film as a surface protective layer, and no circuit short-circuiting occurs in an environment of a temperature of 85°C and relative humidity of 85%, and after an electricity conduction test of 1000 hours.

Furthermore, after the circuit board passed through the electrolytic gold plating step has been treated in the replacement water which contains 1 wt% of Mg ions, the insulating resin film has been isolated from the circuit board, and elongation after fracture has been measured. A result confirms that elongation is larger compared with that in the case of no Mg or Ca replacement, and flexibility can be provided.

### Industrial Applicability

According to the conventional method of adding Mg or Ca in the developing solution or the washing water after development, since the Mg or Ca may be replaced with Na again in the surface treatment step such as plating executed after the heat curing, many Na ions may be present in the insulating film even after the surface treatment. However, by employing the manufacturing process of the present invention, treatment by Mg or Ca added water is executed after heat curing or surface treatment to remove Na, whereby replacement with Mg or Ca can be realized.

Therefore, according to the present invention, it is possible not only to solve the problem of a reduction in environmental resistance caused by water absorption or hydrolysis of the insulating resin film, but also to rectify fragility of the insulating resin film caused by hydrolysis of the resin.

Furthermore, since there is no need to use any highly costly special devices or methods, and improvement can be made while maintaining most stable developing conditions optimal in terms of cost, it is possible to provide a circuit board stably and inexpensively.

## Claims

1. A circuit board which uses a photosensitive insulating resin for a surface protective layer of a circuit wiring pattern, **characterized in that** the photosensitive insulating resin is constituted by replacing Na ions adsorbed thereon with a polyvalent metal through a treatment step containing Na ions which is executed after a heat curing step of the photosensitive insulating resin.

2. A circuit board which uses a photosensitive insulating resin for an insulating layer between circuit wiring conductor layers of a multilayer circuit board, **characterized in that** the photosensitive insulating resin is constituted by replacing Na ions adsorbed thereon with a polyvalent metal through a treatment step containing Na ions which is executed after a heat curing step of the photosensitive insulating resin.

3. The circuit board according to claim 1 or 2, **characterized in that** the polyvalent metal belongs to a II group.

4. The circuit board according to claim 1 or 2, **characterized in that** the polyvalent metal is Mg or Ca.

5. A method of manufacturing a circuit board which uses a photosensitive insulating resin for a surface protective layer of a circuit wiring pattern, **characterized by** replacing Na ions adsorbed on the photosensitive insulating resin with a polyvalent metal through a treatment step containing Na ions which is executed after a heat curing step of the photosensitive insulating resin.

6. A method of manufacturing a circuit board which uses a photosensitive insulating resin for an insulating layer between circuit wiring conductor layers of a multilayer circuit board, **characterized by** replacing Na ions adsorbed on the photosensitive insulating resin with a polyvalent metal through a treatment step containing Na ions which is executed after a heat curing step of the photosensitive insulating resin.

7. The method according to claim 5 or 6, **characterized in that** the polyvalent metal belongs to a II group.

8. The method according to claim 5 or 6, **characterized in that** the polyvalent metal is Mg or Ca.
